# EUROPEAN PATENT APPLICATION

(11) **EP 1 229 585 A1**
(43) Date of publication of application: **07.08.2002**
(21) Application number: 02002474.1
(22) Date of filing: 01.02.2002
(51) Int. Cl.: H01L 27/082, H01L 21/8222

(54) **Integrated circuit with bipolar transistors having different emitter base junction widths**

(30) Priority: 02.02.2001 JP 2001026456
(71) Applicant: NEC CORPORATION, Tokyo (JP)
(72) Inventor: Sato, Akira, c/o NEC Yamagata,Ldt., Yamagata-shi, Yamagata 990-0821 (JP)
(74) Representative: Glawe, Delfs, Moll & Partner

(57) **Abstract**

An integrated circuit comprises a plurality of bipolar transistors. In an exemplary embodiment, each bipolar transistor includes a buried collector region configured in a semiconductor substrate, extrinsic base regions configured in the surface region of the substrate, and an emitter base junction. The emitter base junctions of the bipolar transistors have different emitter contact widths.

## Description

### BACKGROUND OF THE INVENTION

### 1. Field of the Invention

The present invention relates to integrated circuits, and more particularly relates to integrated circuits including bipolar transistors.

### 2. Description of the Related Art

A continuing trend in fabrication of bipolar transistors for silicon integrated circuits is to build high speed and performance bipolar transistors in integrated circuits. The drive toward this high speed and performance elements in integrated circuits has resulted in continued shrinking of device and circuit features. Such shrinking is intended to shorten carrier travel time by reducing collector base parasitic capacitances, lowering base resistances and accomplishing shallow emitter base junctions.

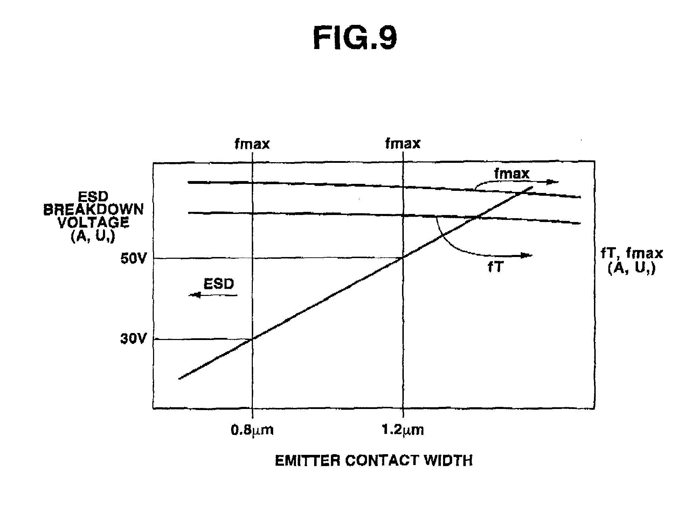

The emitter base junction of a bipolar transistor has an emitter contact width.. As is known to one ordinary skill in the art, shrinking emitter contact width would lower electrostatic discharge (ESD) breakdown voltage of the bipolar transistor. The relationship between ESD breakdown voltage and emitter contact width is illustrated in Figure 9. Excessively low ESD breakdown voltage might causes serious damage on the bipolar transistors in an integrated circuit.

Various measures have been proposed to solve or alleviate this problem. One such measure is to use an ESD protection circuit. Coupling such ESD protection circuit to bipolar transistors in an integrated circuit would alter the device characteristic. Thus, the use of ESD protection circuit is not appropriate where the device characteristic of the integrated circuit should remain unaltered. Other measure is to increase emitter base junction area to avoid the excessive concentration of electric field. If this measure is employed, the chip size will increase considerably, deteriorating high frequency characteristic of bipolar transistor. Thus, this measure is not satisfactory.

Accordingly, a need remains for development of an integrated circuit with bipolar transistors, which combines high frequency transistor characteristic with sufficiently high ESD breakdown voltage.

### SUMMARY OF THE INVENTION

The present invention seeks to provide an integrated circuit and a method of forming bipolar transistors for an integrated circuit, in which the above-mentioned problems are avoided or reduced.

According to one aspect of the present invention, there is provided an integrated circuit, comprising:
a semiconductor substrate including a surface region; and
a plurality of bipolar transistors, each having an emitter base junction in the surface region of the semiconductor substrate,
the emitter base junctions of the plurality of bipolar transistors having different emitter contact widths.

According to another aspect of the present invention, there is provided a method of forming a plurality of bipolar transistors for an integrated circuit, comprising:
providing a semiconductor substrate for an integrated circuit;
providing a conductive layer;
providing a masking layer over the conductive layer;
patterning and etching the masking layer to define a plurality of openings therethrough and through the underlying conductive layer exposing a plurality of selected regions of the substrate within bottoms of the plurality of openings and exposing sidewalls of the conductive layer, said selected regions defining emitter base junction areas of the plurality of bipolar transistors, respectively;
removing the masking layer;
providing an isolation layer including sidewall spacers on the exposed sidewalls of the conductive layer;
forming intrinsic base regions within the openings, respectively;
forming emitter structures within the openings, respectively, each of the emitter structures including a layer of an emitter material filling one of the openings in the conductive layer of the first conductivity type, the emitter material of each of the emitter structures being isolated from the conductive layer by the sidewall spacers and forming an emitter base junction within the underlying intrinsic base region within the one opening,
the emitter base junctions having different emitter contact widths.

### BRIEF DESCRIPTION OF THE DRAWINGS

The foregoing and other objects, features and advantages of the invention will be apparent from the following more particular description of exemplary embodiments of the invention as illustrated in the accompanying drawings. The drawings are not necessarily scale, emphasis instead being placed upon illustrating the principles of the invention.

Figures 1 to 7 are schematic cross sectional views summarizing processes in the fabrication sequences.

Figure 8 is a fragmentary top plan view a masking layer.

Figure 9 is a graph illustrating the relationships between ESD breakdown voltage and emitter contact width and between high frequency characteristic and emitter contact width.

### DESCRIPTION OF THE EMBODIMENTS

The process steps and structures described below do not form a complete process flow for forming bipolar transistors for an integrated circuit. The present invention can be practiced in conjunction with integrated circuit fabrication techniques currently used in the art, and only so much of the commonly practiced process steps are included as are necessary for an understanding of the present invention. The figures representing cross sections of portions of a device during fabrication are not drawn to scale, but instead are drawn to illustrate the features of the present invention.

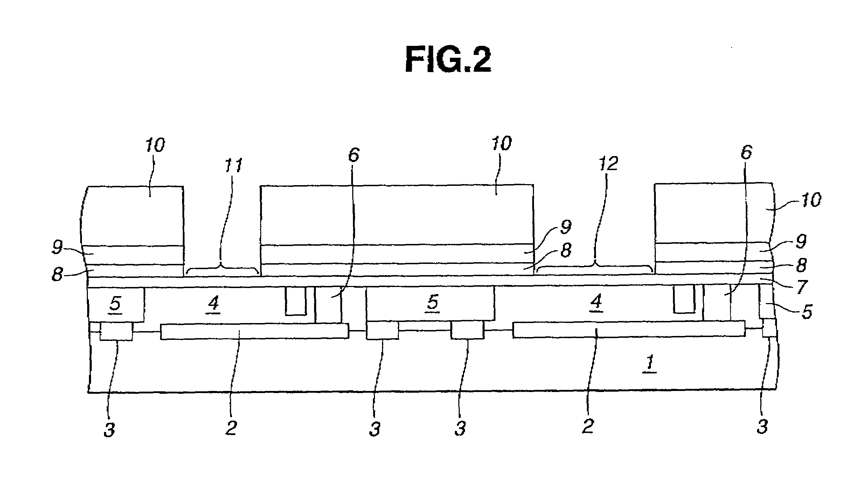

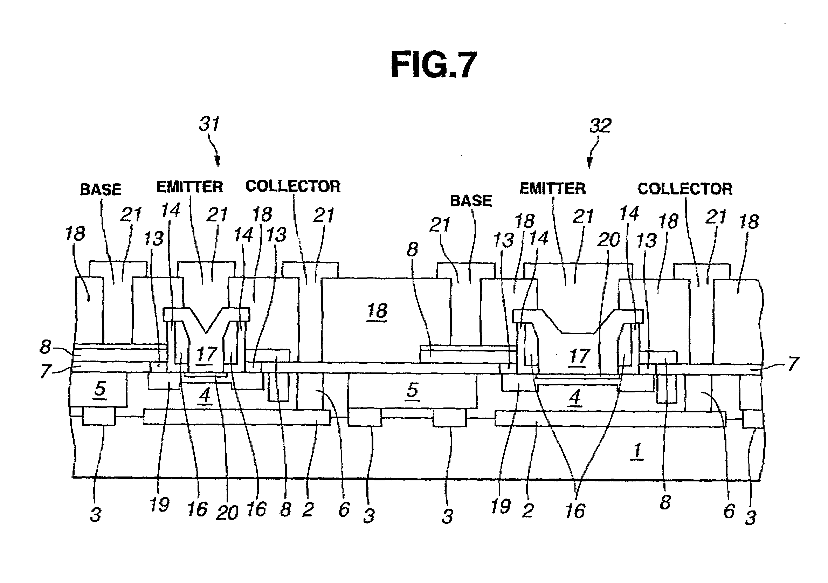

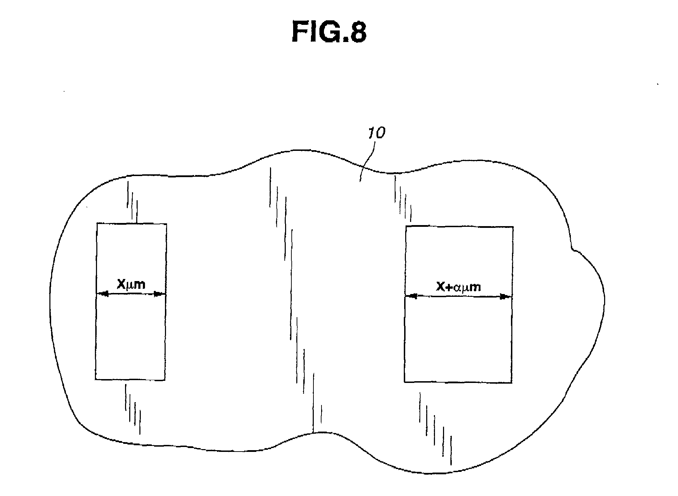

With reference to Figure 7, there is illustrated a portion of an exemplary embodiment of an integrated circuit (IC) according to the present invention. In the embodiment, the IC comprises a plurality of circuit elements including at least one internally connected circuit element in the form of a first bipolar transistor 31, i.e., a circuit element internally connected to another or other circuit element(s), and at least one externally connected circuit element in the form of a second bipolar transistor 32, i.e., a circuit element externally connected to another or other device. The exemplary embodiment provides the first bipolar transistor 31 with high frequency characteristic by narrowing its emitter contact width to reduce base collector capacity, and the second bipolar transistor 32 with high ESD breakdown voltage by maintaining its emitter contact width. The emitter contact widths of emitter base junctions of the bipolar transistors 31 and 32 are determined using the illustrated relationships in Figure 9. Except this difference in emitter contact width, the first and second bipolar transistors are the same. Thus, like reference numerals are used in Figure 7 to denote like portions or parts. In order to fabricate such bipolar transistors 31 and 32, a masking layer 10 is used and provided in patterning and etching processes to define a plurality of openings through the underlying body including a conductive layer 8 of the first conductivity type as shown in Figure 2. As best seen in Figure 8, the openings are two rectangular openings having different widths, namely, a first opening with a width of X µm, and a second opening with a width X + α µm. The masking layer 10 has such first and second openings over the selected regions or desired locations of emitter base junctions 20 (see Figure 7) of the first and second bipolar transistors 31 and 32. With continuing reference to Figure 7 as well as Figure 2, the openings defined through the underlying body expose the selected regions 11 and 12 of a semiconductor substrate (1, 4, 7), respectively, within bottoms of the openings, exposing sidewalls of the underlying body including the conductive layer 8. The selected regions 11 and 12 define emitter base junction areas of the first and second bipolar transistors 31 and 32, respectively, which are configured in the surface region of the semiconductor substrate.

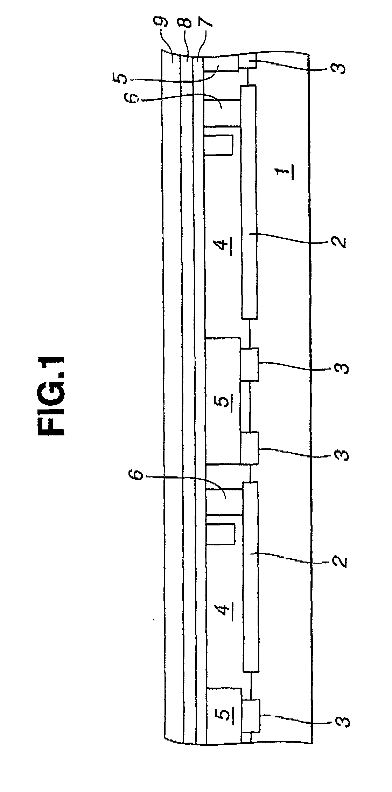

The semiconductor substrate includes a silicon substrate 1 according to the exemplary embodiment. Buried collector regions 2 heavily doped with dopant of a first conductivity type are formed in the substrate surface as shown in Figures 1 to 7. The substrate surface region includes so-called guard ring regions 3, each surrounding one of the buried collector regions 2, for isolating the adjacent circuit elements from each other in cooperation with the overlying oxide regions 5. The substrate surface region also includes collector electrodes 6 and a layer 4 of epitaxial silicon lightly doped with dopant of the first conductivity type. The epitaxial layer 4 overlies the buried collector regions 2 and guard ring regions 3. The oxide regions 5 and collector electrodes 6 are buried in the epitaxial layer 4.

With reference again to Figure 7, the first and second bipolar transistors 31 and 32, each, have a buried collector region 2 configured in the semiconductor substrate, extrinsic base regions 19 of a second conductivity type configured in the surface region of the semiconductor substrate, and an emitter base junction 20 between an emitter structure 17 and the underlying intrinsic base region. Each of the emitter structures 17 includes a layer of an emitter material of the first conductivity type filling the emitter opening in the conductive layer 8 that serves as a collector electrode. The emitter material of each of the emitter structure 17 is isolated from the conductive layer 8 by an isolation layer including sidewall spacers (14, 16) and forms an emitter base junction 20 with the underlying intrinsic base region surrounded by extrinsic base regions 16

As mentioned before in connection with Figures 2 and 8, according to the exemplary embodiment, the emitter base junctions of the bipolar transistors 31 and 32 have different emitter contact widths. In particular, the emitter base junction of the first bipolar transistor 31 has a first emitter contact width X µm, while the emitter base junction of the second bipolar transistor 32 has a second emitter contact width X + α µm, which greater or wider than the first emitter contact width.

Clearly, the exemplary embodiment describes a structure including a NPN bipolar transistor or PNP bipolar transistor as the first and second bipolar transistors 31 and 32.

In a method of forming bipolar transistors 31 and 32 for an integrated circuit, a substrate for an integrated circuit in the form of a semiconductor substrate is provided. The semiconductor substrate includes a silicon substrate 1. As shown in Figure 1, buried collector regions 2, heavily doped with N-type dopant, are configured in the substrate surface. The substrate surface region includes a layer 4 of epitaxial silicon lightly doped with N-type dopant. Buried in the epitaxial layer 4 are guard ring regions 3, each surrounding one of the buried collector regions 2, for isolating the adjacent circuit elements from each other in cooperation with the overlying field isolation oxide regions 5, and collector electrodes 6 contacting with the buried collector regions 2. The surface of the semiconductor substrate is planarized to expose the epitaxial layer 4, field isolation oxide regions 5 and collector electrodes 6. The substrate surface of overlaid by a surface oxide film layer 7. A conductive layer 8, in the form of a polysilicon layer of P conductivity type, is provided over the surface oxide film layer 7. A nitride film 9 is deposited over the polysilicon layer 8.

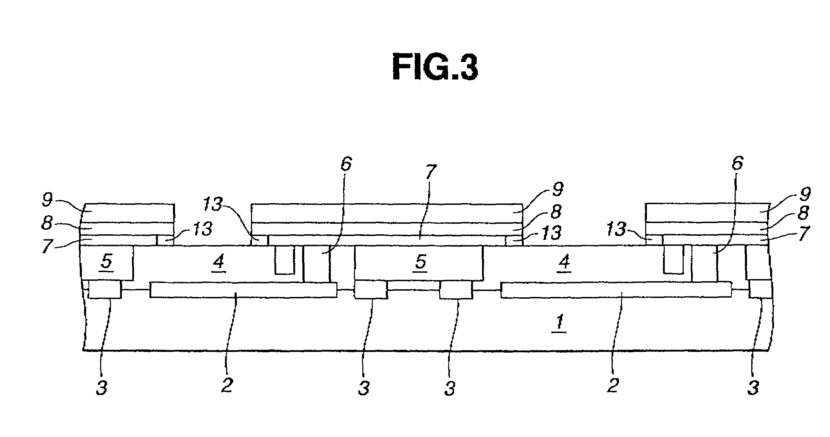

With reference to Figures 2 and 8, patterning and etching processes using a masking layer 10 are described. The masking layer 10 has a first opening with a width of X µm, and a second opening with a width X + α µm over the selected regions 11 and 12 of the semiconductor substrate where emitter base junctions 20 (see Figure 7) are desired to be located. The etching, using the masking layer 10, defines openings through the underlying nitride layer 9 and conductive layer 8. Then, with another etching using the same making layer 10, the surface oxide film layer 7 is removed and an undercut to produce an overhang in the overlying conductive layer 8 (see Figure 3). As a result, the selected regions 11 and 12 are of the substrate are exposed within the bottoms of the openings and sidewalls of the layers 7, 8 and 9 are exposed.

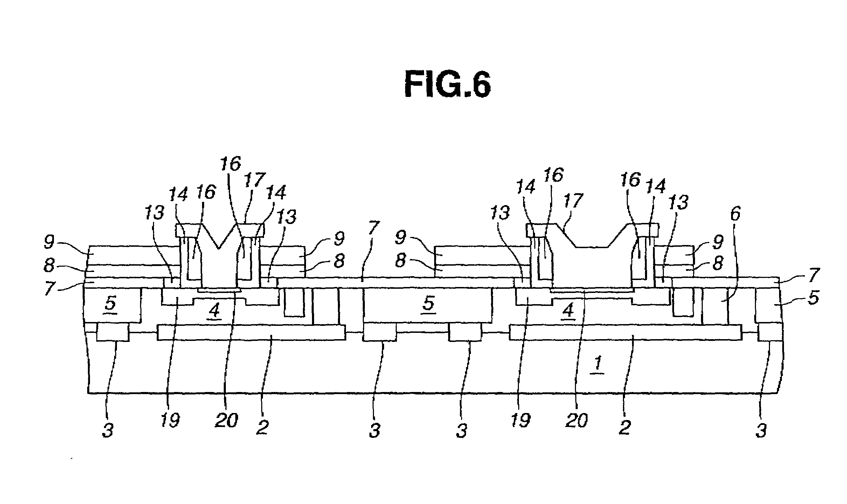

With reference to Figure 3, a polysilicon material is grown to fill the openings and the undercuts in the surface oxide film layer 7 and selectively removed leaving portions filling the undercuts, forming base contacts 13 between the conductive layer 8 and extrinsic base regions 19 (see Figures 6 and 7). Subsequently, the masking layer 10 is removed.

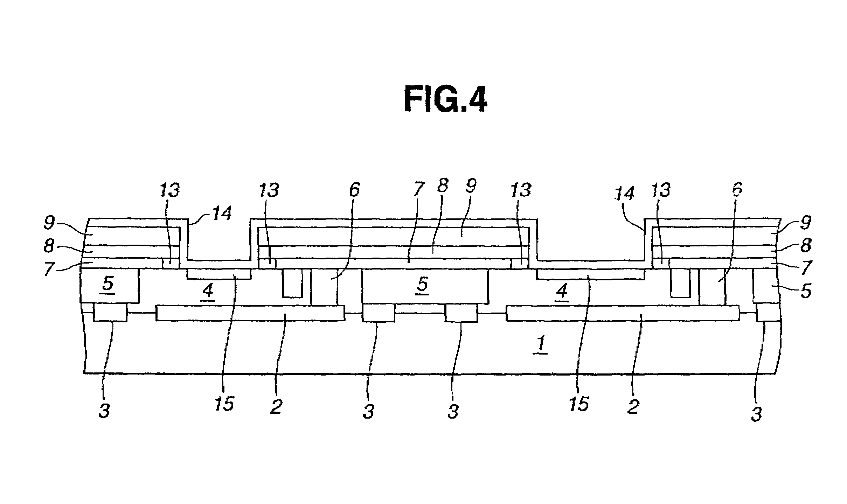

With reference to Figure 4, an oxide film 14 is deposited overall, for example, by growing process. Active base regions 15 are formed below the selected regions 11 and 12 by an appropriate method, such as, ion implantation through the oxide film 14.

Subsequently, a nitride film 16 is deposited overall, for example, by growing process.

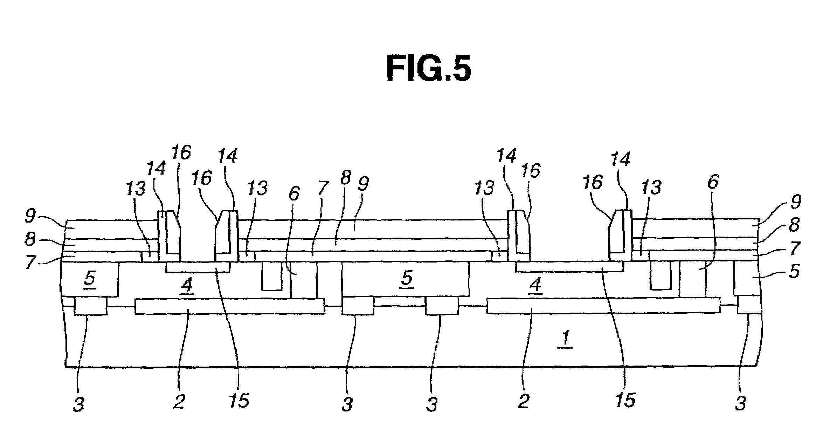

With reference to Figure 5, the nitride film 16 and the underlying oxide film 14 are anisotropically etched back, to leave sidewall spaces (14, 16) on sidewalls of base contacts 13, conductive layer 8 and nitride layer 9. Subsequently, the portions of the oxide film 14 are removed to expose the selected regions 11 and 12 where emitters are to be formed.

With reference to Figure 6, a layer of emitter material in the form of a polysilicon layer 17, is deposited overall to fill the emitter openings defined by the sidewall spacers and etched back using an appropriate masking layer, not shown, to leave portions forming emitter structures 17. The layers 8 and 9 are etched leaving base electrodes 8 and the overlying nitride layer 9 portions. Due to heat of the polysilicon layer 17, dopant within the active regions 15 are diffused to form extrinsic base regions 16 and intrinsic base regions.

Each of the emitter structures 17 in the emitter openings forms an emitter base junction, and it is isolated from the base contacts 13 by the sidewall spacers (14, 16).

With reference to Figure 7, an insulating layer 18 is deposited overall, and conventional metallization steps are provided, including contact 21 formations to the collector base and emitter.

Clearly, while the embodiment describes a process for formation of NPN bipolar transistors, PNP bipolar transistors could by provided by a complementary process to provide elements of opposite conductivity type, if desired.

While the present invention has been particularly described, in conjunction with the exemplary embodiments, it is evident that many alternatives, modifications and variations will be apparent to those skilled in the art in light of the foregoing description. It is therefore contemplated that the appended claims will embrace any such alternatives, modifications and variations as falling within the true scope and spirit of the present invention.

## Claims

1. An integrated circuit, comprising:
a semiconductor substrate including a surface region; and
a plurality of bipolar transistors, each having a an emitter base junction in the surface region of the semiconductor substrate,
the emitter base junctions of the plurality of bipolar transistors having different emitter contact widths.

2. An integrated circuit, comprising:
a semiconductor substrate including a surface region;
an internally connected circuit element in the form of a first bipolar transistor including an emitter base junction, in the surface region of the semiconductor substrate, having a first emitter contact width; and
an externally connected circuit element in the form of a second bipolar transistor including an emitter base junction, in the surface region of the semiconductor substrate, having a second emitter contact width,
the second emitter contact width being greater than the first emitter contact width.

3. A method of forming a plurality of bipolar transistors for an integrated circuit, comprising:
providing a semiconductor substrate for an integrated circuit;
providing a conductive layer over the substrate;
providing a masking layer over the conductive layer;
patterning and etching the masking layer to define a plurality of openings therethrough and through the underlying conductive layer exposing a plurality of selected regions of the substrate within bottoms of the plurality of openings and exposing sidewalls of the conductive layer, said selected regions defining emitter base junction areas of the plurality of bipolar transistors, respectively;
removing the masking layer;
providing an isolation layer including sidewall spacers on the exposed sidewalls of the conductive layer;
forming intrinsic base regions within the openings, respectively;
forming emitter structures within the openings, respectively, each of the emitter structures including a layer of an emitter material filling one of the openings in the conductive layer, the emitter material of each of the emitter structures being isolated from the conductive layer by the sidewall spacers and forming an emitter base junction within the underlying intrinsic base region within the one opening,
the emitter base junctions having different emitter contact widths.

4. A method of forming a plurality of bipolar transistors for an integrated circuit, comprising:
providing a semiconductor substrate for an integrated circuit;
providing a conductive layer over the substrate;
providing a masking layer over the conductive layer;
patterning and etching the masking layer to define a plurality of openings therethrough and through the underlying conductive layer exposing a plurality of selected regions of the substrate within bottoms of the plurality of openings and exposing sidewalls of the conductive layer, said selected regions defining emitter base junction areas of a first bipolar transistor and a second bipolar, respectively;
removing the masking layer;
providing an isolation layer including sidewall spacers on the exposed sidewalls of the conductive layer;
forming intrinsic base regions within the openings, respectively;
forming emitter structures within the openings, respectively, each of the emitter structures including a layer of an emitter material filling one of the openings in the conductive layer, the emitter material of each of the emitter structures being isolated from the conductive layer by the sidewall spacers and forming an emitter base junction within the underlying intrinsic base region within the one opening,
the emitter base junction of the first bipolar transistor having a first emitter contact width, the emitter base junction of the second bipolar transistor having a second emitter contact width greater than the first emitter contact width.
